# EUROPEAN PATENT SPECIFICATION

(11) **EP 0 423 184 B1**
(45) Date of publication and mention of the grant of the patent: **20.10.1993**
(21) Application number: 89907842.2
(22) Date of filing: 07.07.1989
(51) Int. Cl.: H05K 3/34

(54) **DEVICE FOR RAPID APPLYING OF PASTES AND ADHESIVES AT DISCRETE POINTS, ESPECIALLY FOR SURFACE MOUNTING OF COMPONENTS AT CIRCUIT CARDS**
VERFAHREN ZUM SCHNELLEN ANBRINGEN VON PASTE UND KLEBEMITTELN AN BESTIMMTE STELLEN, INSBESONDERE FÜR DIE MONTAGE AN DER OBERFLÄCHE VON HALBLEITERKARTEN
DISPOSITIF D'APPLICATION PONCTUELLE RAPIDE DE P TES ET D'ADHESIFS, NOTAMMENT POUR LE MONTAGE EN SURFACE DE COMPOSANTS SUR DES CARTES DE CIRCUITS

(30) Priority: 08.07.1988 SE 8802571
(43) Date of publication of application: 24.04.1991
(73) Proprietor: Mydata Automation AB, 168 66 Bromma (SE)
(72) Inventor: STRIDSBERG, Lennart, S-122 42 Enskede (SE)
(74) Representative: Hopfgarten, Nils
(86) International application number: SE8900397
(87) International publication number: WO9000852

(56) References cited:
- Elteknik med aktuell elektronik; No. 21, issued 3 December 1987 in Stockholm, Sweden, (ISSN 0346-6310), B. Olsson: "Svart att ställa om till ytmontering", see pages 44-46.
- Elteknik med aktuell elektronik, No. 18, issued 20 October 1988 in Stockholm, Sweden, (ISSN 0346-6310), S. ekh: "Lödpasta och lim skapar problem", see pages 28, 29 and 31.

## Description

The present invention relates to a device for placing, with a high speed, small volumes of glue, tin paste and other materials on a normally flat surface. An important application of the invention is applying soldering paste to circuit pattern boards. In surface mounting components on circuit boards it is in many cases required that all soldering islands, before the mounting of the components, are provided with an amount of soldering paste, which is adapted to said soldering island and the future component legs. Hereby it is required that the volume placed on each soldering island can be determined individually and that the applied volumes are maintained within certain tolerances.

To be able to keep steps with following mounting machines a very high capacity is required. An ordinary integrated circuit of type SOL-20 can in many systems be mounted in 1-2 seconds. To be able to keep the same speed a soldering paste applying machine must place 20 soldering paste points in 1-2 seconds or 20-10 per second.

Since the invention is suited for applying and metering of many different materials besides soldering paste and glue the word Material will be used in the following.

The existing equipments for a pointwise application have a low speed. The majority are based on using a given pressure during an adaptable time to press Material through a tube (nozzle) having a given interior diameter, which gives a low repeatability. The few systems using some kind of volume determination by means of mechanical methods have heavy volume determining heads, which are moved upwards and downwards for each point to be applied. This gives slow movements and a low capacity.

Instead of applying soldering paste pointwise normally screen printing is used, which, however, gives long set up times. The same method is also sometimes used for other materials, e.g. glue.

The principal purpose of the invention is to provide a device which will make it possible to apply or meter with a very high speed Material in small points having a volume, which can be chosen within certain limits, and with a good repeatability for the volume chosen.

This is accomplished with a device, the particular features of which appear from the accompanying claims.

Thus a device is provided to apply Material such as pastes and glue in discrete points, particularly for placing soldering paste on electronic circuit cards for cooperation with a following mounting machine. The applying device comprises a pump house and Material is fed from a container to said pump house by means of a pipe. Furthermore, there is a nozzle to feed said material out from the pump house. The feeding in of Material is suitably produced by means of a pressure above atmospheric acting on the Material inside the Material container and the feed into said pump house is controlled by an upper valve device. This upper valve device will at predetermined times block the input of material to the pumping chamber which is located inside the pump house. In order to control the feed out from the pumping chamber a corresponding lower valve device is provided adjacent to the outlet of the pumping chamber or some suitable restriction device which is located there. The essential part of the pump house, which performs the pumping operation, is constituted by a body of a piezo electric material. This body is provided with an interior cavity, the volume of which is reduced or increased depending on an electrical field, which is applied over said piezo electric body. The electric field is produced by means of electrodes which are located adjacent to the piezo electric body and are connected to a generator for a drive voltage. With a suitable orientation of the piezo electric material in the pumping body the volume of the cavity inside the piezo electric body will depend on the voltage which is applied between the electrodes.

In order to increase the effect of said change of volume, when a voltage is applied over the piezo electric material, the inner cavity of said pumping body can be reduced. This is accomplished by the method that a suitable filling material, which is easily plastically or elastically deformable, is placed inside said cavity in the pumping body and is suitably attached to the walls thereof.

The pumping body can have the shape of a tubular means, the inner envelope surface of which is coated with the filling material.

The valve devices comprise in the ordinary way a valve element or a valve body and this may be realized as a flat element. This flat element may have the shape of a band or a rotatable disc and is provided with through holes, through which said material will pass when the valve is opened. In a particular embodiment having both upper and lower valve devices the valve elements are realized by a single band passing through both valve devices. This gives a particular advantage, when an elongation or a reduction of the distance between said two valve devices are produced in a pump stroke.

In another embodiment no lower valve device is provided and here only a restriction is provided and the restriction is suitably realized by the nozzle itself. By means of this construction fewer movable parts are obtained but with the majority of Materials it will give a less secure repeatability of the volume, with which said pump house is filled, when the upper valve is opened.

The invention will now be more closely described with reference to the accompanying drawing figures.

Fig. 1 shows an embodiment of a glue and soldering paste applying machine according to the invention.

Fig. 2 shows an embodiment of a Material metering head according to the invention. The figure shows a section through said head in two projections perpendicular to each other.

Fig. 3 shows in subfigures a) - g) the operation of the illustrated embodiment of the material metering head in a chronologic order.

Fig. 4 shows an embodiment of the control of the valve band for the embodiment shown in Fig. 2 of a Material metering head according to the invention.

Fig. 5 shows other embodiments of the control of a valve band for the embodiment shown in Fig. 2 of a Material metering head according to the invention.

Fig. 6 shows an alternative embodiment. Here a rotating valve element is used for the upper valve function. The lower valve function has been omitted in this case.

The main part of the machinery is the applying device 110. This is mounted on a carriage 120, which is movable along a path 130 and can be transported in the X-direction along this by means of a motor 131. The exact realization of said means 130 - 131 is not essential to the invention.

The material is ejected by means of the nozzle 111 towards the target 140, which may be a pattern board. The material is preserved in a container 112.

Apparently said pattern board 140 must be able to be displaced in the Y-direction in relation to the path 130. If this is produced by the method that the board or the path is movable in the Y-direction, is not relevant to the invention.

For a correct operation said head 110 is movable in the height direction by means of a motor 121. To be able to directly measure the level of said board a distance finder 150 is provided. In an embodiment of this kind there is a feeler, which may temporarily be lowered to check the distance of said head 110 and the board 140.

A camera 190 is used for locating reference points on said board in such a way that the associated control system can make corrections for boards which have been placed obliquely, have been mounted displaced in the X- or the Y-directions, and to make corrections for the fact that the soldering islands are not exactly oriented in relation to the borders of said board.

The camera can also be used for measuring Material points, which are placed on the testing surface 160 at the side of the board 140. By adapting the head 110 for a certain volume of the applied point and thereafter by said camera and an image treating equipement sense the size of the resulting point it is possible, through the control computer of the system, to obtain a feed back between the set and the real volume.

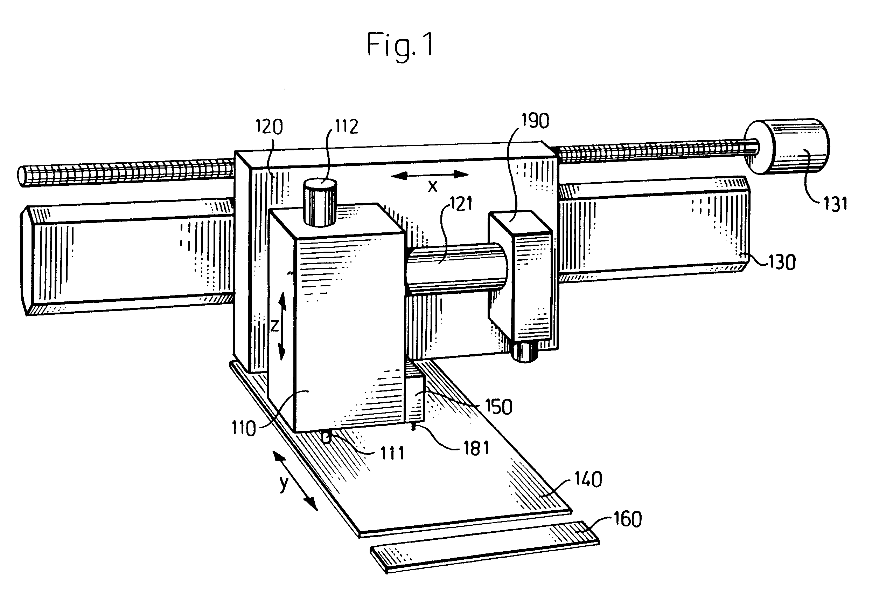

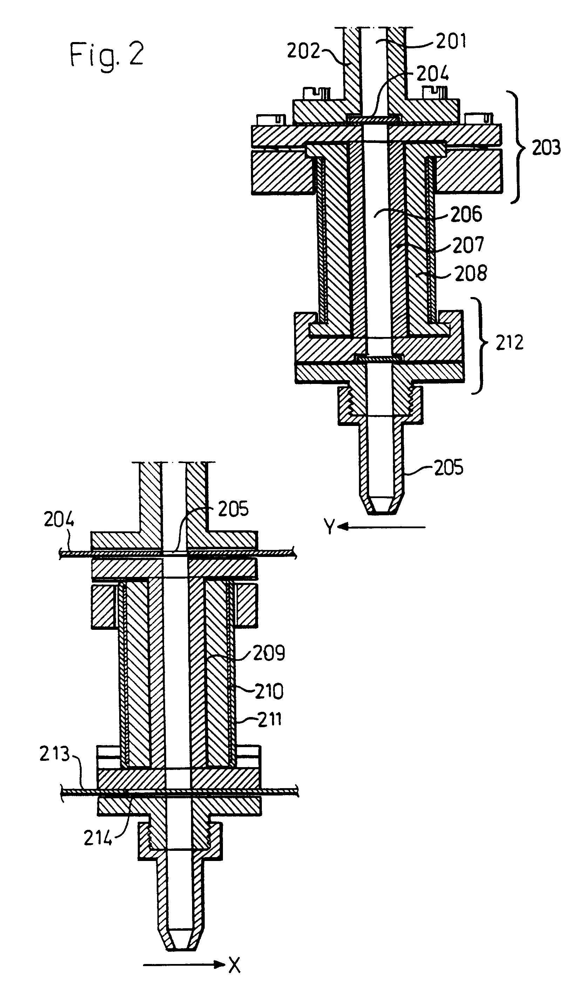

The Material 201 (see Fig. 2) is contained in the container 112 (Fig. 1). The container 112 is subjected to an over atmospheric pressure, e.g. by the fact that pressurized air is fed to the upper part of said container. Through the pipe 202 Material is fed down to the upper valve housing 203.

In the valve housing a band 204 is provided having at least one hole 205. The band can be displaced forwards and backwards in the X-direction in such a way that in one position said hole 205 lets Material flow through from said pipe 202 down to the pumping chamber 206. In another position the band 204 blocks the Material flow; Material can then no longer be moved from the tube 202 to the pumping chamber 206.

The pumping chamber 206 is a cavity in the passive pumping chamber reduction 207.

The active pumping work is performed by the pump house 208. This is realized of a piezo-electric material. At the inner side of the pump house 208 an electrode surface 209 is located. At the exterior side there is another electrode surface 210. At least one of these is well isolated. In the embodiment illustrated the electrode 209 is grounded and the electrode 210 is connected to a generator for a drive voltage. An isolation 211 protects against an unintentional contact.

By choosing and orienting the material of the pump house 209 in a suitable way it is possible to obtain a relationship between the electric voltage, which is applied between the electrodes 209 and 210, on one side and the volume of the interior cavity of the pump house 208 on the other side. This change of volume is reinforced by the passive pumping chamber reduction 207 by the fact that the volume of this is kept unchanged during the pumping operation and hereby allows that the same absolute change of volume of the cavity of the pump house 208 is forced to the smaller volume 206.

The lower valve housing 212 is directly attached to the base part of the pump house 206. Therefore this will move upwards and downwards in relation to the upper valve housing 203.

In the valve housing 212 there is also a band 213 having at least one hole 214. The band can be moved forwards and backwards in the X-direction in such a way that in one position the hole 214 lets Material flow from the pumping chamber 206 to the nozzle 215. In another position the band 213 blocks the flow of Material.

The pump house 208 is in the embodiment illustrated in the figures a tubular body, the inner bore or hole or which may have an arbitrary section, for instance rectangular. The passive pumping chamber reduction 207 will then also be a cylindric body located inside the interior bore of the pumping tube 209. The pumping body 209 may furthermore be provided with flanges or protruding parts at its upper and lower ends, which thus extend in the cross direction. By means of these flanges and suitable recesses the pump house is retained in the upper and lower valve housings. The retainer recesses may be realized as clamping devices, the clamping effect of which is accomplished by means of suitably located screws.

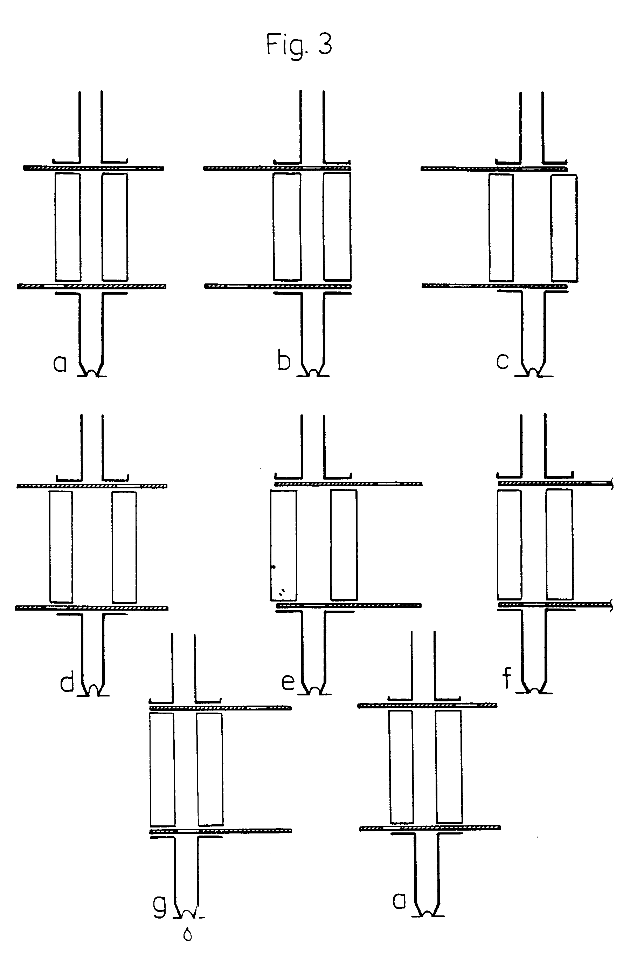

The operation of the illustrated embodiment of a Material metering head will now be described by means of Figure 3, which in its subpart figures a) - g) shows a chronologic sequence of events. In subfigure
a) both valves are closed and the point of the nozzle 215 is not completely filled; the pressure inside the pumping chamber is approximately equal to the surrounding atmospheric pressure,
b) the upper valve is opened and the pressure inside the pumping chamber 206 increases to the pressure inside the Material container 112.
c) the voltage is changed in such a way, that the volume of the pumping chamber is increased. Material will then be pressed into the pumping chamber but will not flow any further.
d) the upper valve is closed. The pressure inside the pumping chamber is approximately equal to the pressure inside the Material container 112.
e) the lower valve is opened. The pressure inside the pumping chamber will fall to the surrounding atmospheric pressure. The point of the nozzle 215 is filled a little, since the pumping chamber, due to the reduced pressure, will shrink a little and the valve band 204 is somewhat pressed down (earlier the same pressure acted on both sides of the band 204).
f) the voltage is slowly changed in such a way, that the volume of the pumping chamber is slowly reduced. If it is supposed, that this voltage is changed in a suitable amount, the point of the nozzle 215 will be filled, until it has been filled nearly out to the edge of the point. (This step of operation can be omitted in certain cases.)
g) the voltage is changed rapidly in such a way, that the volume of the pumping chamber is rapidly reduced. The point of the nozzle 215 is already filled and the rapidly increasing pressure will produce an ejected droplet, which will leave the nozzle approximately straight downwards. After the ejection the point of the nozzle 215 will not be completely filled in certain cases.

a) the lower valve is closed. Both valves are now closed and the point of the nozzle 215 is not completely filled; the pressure of the pumping chamber is approximately equal to the surrounding atmospheric pressure.

In figure 3 the movements of the pump house 208 are illustrated as if it only will change its dimensions in the X-Y-direction. It will also change its dimension in the Z-direction, which has not been drawn in Figure 3.

The two bands 204 and 213 can either be moved independent of each other or be simultaneously displaced by a common motor.

The expression "band" used for the elements 204 and 214 does not mean, that both of these necessarily must be thin. By realizing the lower valve 212 as a thin tensioned band of for instance stainless steel it is, however, possible to simply solve the coupling of control forces for the valve element 214 without having to unnecessarily inhibit the Z-movement of the lower part of the pump house 208.

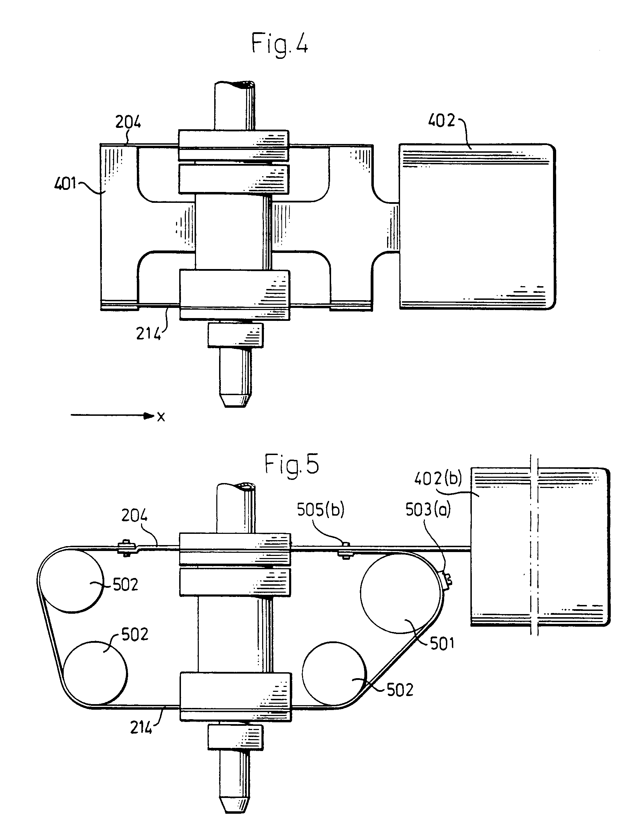

Figure 4 shows an embodiment of the control of the valve bands 204 and 214. The control consists of an element 401, which is movable in the X-direction. The upper valve band 204 can be realized of one part of the element 401 or alternatively be clamped in the same way as is schematically illustrated for the band 213.

The movement is executed by the element 402, which may be a pneumatic cylinder, a magnet, a linear "voice-coil-motor" or a similar device. Alternatively a rotative motor can be coupled to the element 401 through an excenter.

Figure 5 shows two other embodiments of the control of the valve bands 204 and 214. The control consists of a roller 501 and three rollers 502. In this same Figure 5 two alternative embodiments are shown, a) and b).

In the embodiment a) the valve bands are constituted by a single band 204-213, which completes a full turn around the rollers 501-502. The band is joined together in the middle of the roller 501 by means of the device 503, which simultaneously locks said band onto the roller. The band is displaced by the fact that said roller is driven by a motor.

In the embodiment b) the valve band 204 is simultaneously a coupling to a linear motor 402, which may be a pneumatic cylinder, a magnet, a linear "voice-coil"-motor or similar device. The band 213 completes a full turn around said rollers 501-502. The band is joined to the driving arm/valve band 204 by means of the joints 505.

Voice-coil-control allows a very rapid displacement of the bands and offers together with the very rapid changes of forces in the walls of the pump house 208 the possibility of a very rapid feed of Material. The speed of the components in question can be kept so high that the speed, with which it is possible to make the material to be pressed down into the pumping chamber, is a not unessential limiting factor of the capacity of the Material metering head.

If it is supposed, that the surface, upon which the Material will be applied, has no elevated parts, the Material metering head according to the invention can be transported at a small distance above said surface. Hereby it is only required to be moved in the X- and Y-direction in relation to the surface, to which the Material is to be applied. By the fact that it does not have to be moved in the said direction, one movement is eliminated, which is often time consuming.

It is evident, that the ejected volume can be controlled within certain limits by varying the amplitude of the electric voltage change.

Several pump houses according to the illustrated embodiments can be assembled, possibly having a common driving device for the valve bands. In such a case advantageously the upper valve housings 203 can be built together while the lower valve housings 212 must be separated. In the case where the driving device for the valve bands is common, the drive voltages are only activated for those pump houses, which one wants to activate. Passive pump houses can, if so is desired, be given a very small driving voltage opposite to the normal one in order to achieve a weak backwards pumping which will compensate for the small flow which otherwise would be produced during a longer series of passive pumping cycles due to the elasticity of the valve bands and the pump houses.

Such pump houses in parallel may have a value for metering different Materials or to allow the metering of the same material in volumes having such different sizes that this in practice can not be realized by means of different driving voltage applied to only one pump house 208.

In many cases the lower valve function can be omitted (corresponding to the valve housing 212 in the embodiment according to Figure 2). By choosing suitable opening times for the upper valve function (corresponding to the valve housing 203 in the embodiment according to Figure 2) the filling of the pumping chamber may still in many applications be sufficiently repeatable. The restriction, which is often suitable because of other reasons, of the point of the nozzle 215 will assist here, since this restriction in combination with the often very high viscosity of the Material gives a larger flow resistance in the point of the nozzle 215 than in the pumping chamber 206 and in the rest of the nozzle 215. For some Materials the restriction in combination with the viscosity of the material can inhibit the flow at the feed pressure choosen. In order to facilitate the filling of Material it may in many cases be suitable to superpose an alternating voltage on the change of direct voltage, which causes the volume change in the operation stroke corresponding to Figure 3c. The alternating voltage produces vibrations of the walls of the pumping chamber 206 and are operative to shake down the Material through the pumping chamber 206.

The valve function corresponding to the valve housings 203 and 212 has in the embodiment been realized by means of band valves. Apparently, these may be replaced by sliding valves, for instance by the way that the bands 204 and 213 are made thicker.

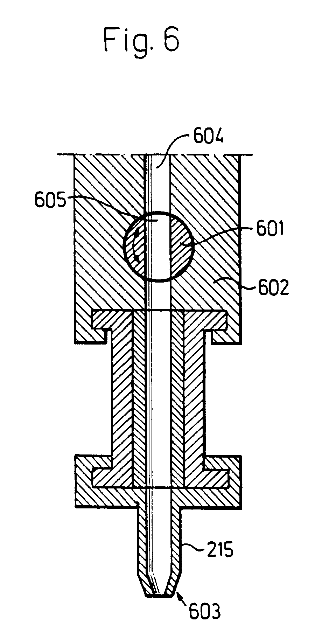

An alternative embodiment is shown in Figure 6. Here a rotating valve element 601 is used inside a valve housing 602. The valve element 601 is realized by a cylindrical bar, in which a hole passes perpendicular to the axis of said bar and which is rotatable about this axis, which extends perpendicular to the flow direction of the Material through the valve housing. The lower valve function has been omitted in this case. Instead a suitable opening time is used for the valve 601, which in combination with a suitably choosen pressure in the input tube 604 gives an acceptable repeatability of the filling down to the restriction 603 in the nozzle 215. The valve 601 is rotated by means of a motor or similar device. Apparently, with this arrangement of the valves, a number of pumping chambers may also be located in a line having a common valve control (in this embodiment this will mean that in a cylinder bar 601 common to several pumping chambers several bores 605 are drilled, one for each pumping chamber).

The passive pumping chamber reduction (207 in Figure 2) is in Figure 2 drawn as a tube, the exterior part of which is in a precise engagement with the pumping chamber (for instance by being molded into the pumping chamber under a vacuum) and the interior cavity of which is directly engaged with the Material. This is a suitable but not necessary shape. The primary task of the pumping chamber reduction is to form a constant volume in such a way that the volume change of the inner part of the pumping chamber is transferred to a smaller volume filled with Material.

## Claims

1. A device for applying material such as pastes and glue in discrete points having a pump house (208), a tube, with which material is feed to the pump house, a nozzle for feeding out material from the pump house, an upper valve device (203), which is arranged to block the material flow into a pumping chamber (206), which is located inside said pump house, a lower blocking or restricting device (213), which is arranged to block or restrict the material flow from the applying device, **characterized** in that said pump house (208) is realized of a piezo-electric material having electrodes (209,210) connected to a drive voltage generator, said piezo-electric material being choosen and oriented in such a way that the volume of the interior cavity of the pump house depends of the voltage, which is applied between said electrodes.

2. A device according to claim 1, **characterized** in that said lower blocking or restricting device is realized by a lower valve device (212).

3. A device according to one of claims 1 or 2, **characterized** in that the valve element in at least one valve device is formed by a flat element (204) provided with holes (205), which element is movable essentially perpendicular to the flow direction of the material through the associated valve device.

4. A device according to claim 3, **characterized** in that at least one of the flat valve elements is realized by a band provided with holes.

5. A device according to claim 4, **characterized** in that said valve band elements are arranged to be controlled by an element, which is movable in a direction essentiallY perpendicular to the pumping direction.

6. A device according to one of claims 4-5, **characterized** in that said valve band elements are realized by a single band, which completes a full turn.

7. A device according to one of claims 1-2, **characterized** in that at least one of said valve elements is realized by a valve body, which is rotatable around an axis essentially perpendicular to the flow direction of the material through the associated valve device and which is provided with a hole essentially perpendicular to this axis.

8. A device according to claim 1, **characterized** in that said nozzle itself is realized as a restriction and forms the lower blocking or restricting device.

9. A device according to one of claims 1-8, **characterized** in that said pump house is realized by a tubular element of a piezo-electric material oriented in a suitable way.

10. A device accordingd to claim 9, **characterized** in that the electrodes (209,210) are located on the tubular element at the inner and outer envelope surfaces thereof.

11. A device according to claim 10, **characterized** in that the electrode at the interior envelope surface is grounded and electrically connected to substantially the other parts, of which the pump house is built, while the outer electrode is connected to the drive voltage generator.

12. A device according to one of claims 9-11, **characterized** in that the interior envelope surface of the tubular element is coated with a deformable filling material, whereby the interior volume of the tubular element is reduced and whereby the pumping chamber is formed by the cavity inside this filling material.

## Patentansprüche

1. Vorrichtung zum Auftragen von Material, wie z.B. Pasten und Klebemittel an einzelnen Punkten, die ein Pumpengehäuse (208) aufweist, ein Rohr aufweist, mit dem Material zum Pumpengehäuse Zugeführt wird, eine Düse zum Herausführen des Materials aus dem Pumpengehäuse aufweist, eine obere Schiebervorrichtung (203) aufweist, die angeordnet ist, um den Materialfluß in eine Pumpenkammer (206), die innerhalb des Pumpengehäuses angeordnet ist, abzusperren, eine untere Sperr- oder Drosselvorrichtung (213) aufweist, die zum Sperren oder Drosseln des Materialflusses aus der Auftragvorrichtung angeordnet ist, **dadurch gekennzeichnet**, daß das Pumpengehäuse (208) aus einem piezoelektrischen Material ausgeführt ist und das Elektroden (209, 210) aufweist, die mit einem Steuerspannungsgenerator verbunden sind, wobei das piezoelektrische Material auf eine solche Weise ausgewählt und ausgerichtet ist, daß das Volumen des inneren Hohlraums des Pumpengehäuses von der Spannung abhängt, die zwischen den Elektroden angelegt wird.

2. Vorrichtung nach Anspruch 1, **dadurch gekennzeichnet**, daß die untere Sperr- oder Drosselvorrichtung als eine untere Schiebervorrichtung (212) ausgeführt ist.

3. Vorrichtung nach einem der Ansprüche 1 oder 2, **dadurch gekennzeichnet**, daß das Schieherelement in zumindest einer Schiebervorrichtung als ein flaches Element (204) ausgebildet ist, das mit Löchern (205) versehen ist, wobei das Element im wesentlichen senkrecht zur Flußrichtung des Materials durch die zugehörige Schiebervorrichtung beweglich ist.

4. Vorrichtung nach Anspruch 3, **dadurch gekennzeichnet**, daß zumindest die flachen Schieberelemente als ein Band ausgeführt sind, die mit Löchern versehen sind.

5. Vorrichtung nach Anspruch 4, **dadurch gekennzeichnet**, daß die Schieberbandelemente so angeordnet sind, daß sie durch ein Element gesteuert werden, das in einer Richtung im wesentlichen senkrecht zur Pumprichtung beweglich ist.

6. Vorrichtung nach einem der Ansprüche 4 bis 5, **dadurch gekennzeichnet**, daß die Schieberbandelemente als ein einzelnes Band ausgeführt sind, das eine volle Drehung ausführt.

7. Vorrichtung nach einem der Ansprüche 1 bis 2, **dadurch gekennzeichnet**, daß zumindest eines der Schieberelemente als ein Schiebekörper ausgeführt ist, das um eine Achse im wesentlichen senkrecht zur Flußrichtung des Materials durch die zugehörige Schiebervorrichtung drehbar ist, und wobei der Schiebekörper mit einer Öffnung versehen ist, die im wesentlichen senkrecht zu dieser Achse liegt.

8. Vorrichtung nach Anspruch 1, **dadurch gekennzeichnet**, daß die Düse selbst als eine Drossel ausgeführt ist und die untere Sperr- oder Drosselvorrichtung bildet.

9. Vorrichtung nach einem der Ansprüche 1 bis 8, **dadurch gekennzeichnet**, daß das Pumpengehäuse als ein rohrförmiges Element aus einem piezoelektrischen Material ausgeführt ist, das auf eine geeignete Weise ausgerichtet ist.

10. Vorrichtung nach Anspruch 9, **dadurch gekennzeichnet**, daß die Elektroden (209, 210) auf dem rohrförmigen Element auf dessen innerer und äußerer Hüllfläche angeordnet sind.

11. Vorrichtung nach Anspruch 10, **dadurch gekennzeichnet**, daß die Elektrode auf der inneren Hüllfläche geerdet ist und elektrisch mit den wesentlichen anderen Teilen, aus dem das Pumpengehäuse aufgebaut ist, verbunden ist, während die äußere Elektrode mit dem Steuerspannungsgenerator verbunden ist.

12. Vorrichtung nach einem der Ansprüche 9 bis 11**, dadurch gekennzeichnet**, daß die innere Hüllfläche des rohrförmigen Elements mit einem verformbaren Füllmaterial beschichtet ist, wobei das Innenvolumen des rohrförmigen Elementes reduziert wird und wobei die Pumpenkammer durch den Hohlraum innerhalb dieses Füllmaterials ausgebildet ist.

## Revendications

1. Dispositif pour appliquer une matière telle qu'une pâte ou de la colle en des points séparés, comprenant un corps de pompe (208), un tube par lequel la matière est introduite dans le corps de pompe, une buse pour la sortie de la matière hors du corps de pompe, un dispositif de valve supérieur (203), disposé pour bloquer l'écoulement de matière entrant dans une chambre de pompage située dans ledit corps de pompe, et un dispositif inférieur de blocage ou restriction, disposé pour bloquer ou restreindre l'écoulement de matière sortant du dispositif applicateur,
caractérisé en ce que ledit corps de pompe (208) est réalisé en un matériau piézo-électrique avec des électrodes (209, 210) connectées à un générateur de tension d'actionnement, ledit matériau piézo-électrique étant choisi et orienté de telle manière que le volume de la cavité intérieure du corps de pompe dépend de la tension appliquée entre lesdites électrodes.

2. Dispositif selon la revendication 1, caractérisé en ce que ledit dispositif inférieur de blocage ou restriction est constitué par un dispositif de valve inférieur (212).

3. Dispositif selon l'une des revendications 1 ou 2, caractérisé en ce que l'élément de valve d'au moins un des dispositifs à valve est constitué d'un élément plat (204), prévu avec des trous (205), cet élément étant déplaçable dans une direction essentiellement perpendiculaire à la direction d'écoulement de la matière à travers le dispositif à valve correspondant.

4. Dispositif selon la revendication 3, caractérisé en ce qu'au moins un des éléments de valve plats est constitué par une bande présentant des trous.

5. Dispositif selon la revendication 4, caractérisé en ce que lesdits éléments de valve en forme de bande sont disposés pour être commandés par un élément qui est mobile dans une direction essentiellement perpendiculaire à la direction de pompage.

6. Dispositif selon l'une des revendications 4 et 5, caractérisé en ce que lesdits éléments de valve en forme de bande sont constitués par une bande unique, qui fait un tour complet.

7. Dispositif selon l'une des revendications 1 ou 2, caractérisé en ce qu'au moins un desdits éléments à valve est constitué d'un corps de valve qui peut tourner autour d'un axe essentiellement perpendiculaire à la direction d'écoulement de la matière à travers le dispositif à valve correspondant, et qui est prévu avec un trou essentiellement perpendiculaire à cet axe.

8. Dispositif selon la revendication 1, caractérisé en ce que ladite buse constitue par elle-même une restriction, et constitue le dispositif de blocage ou restriction inférieur.

9. Dispositif selon l'une des revendications 1 à 8, caractérisé en ce que ledit corps de pompe est constitué d'un élément tubulaire en matériau piézo-électrique orienté de façon convenable.

10. Dispositif selon la revendication 9, caractérisé en ce que les électrodes (209, 210) sont placées sur les éléments tubulaires, à l'endroit des surfaces périphériques extérieure et intérieure de celui-ci.

11. Dispositif selon la revendication 10, caractérisé en ce que l'électrode disposée à l'endroit de la surface périphérique intérieure est mise à la terre et connectée électriquement à sensiblement toutes les autres parties constituant le corps de pompe, alors que l'électrode extérieure est connectée au générateur de tension d'actionnement.

12. Dispositif selon l'une des revendications 9 à 11, caractérisé en ce que la surface périphérique intérieure de l'élément tubulaire est revêtue avec une substance de remplissage déformable, le volume intérieur de l'élément tubulaire étant réduit par cette substance, et la chambre de pompage étant formée par la cavité intérieure de cette substance de remplissage.
